# EUROPÄISCHE PATENTSCHRIFT

(11) **EP 2 449 865 B1**
(45) Veröffentlichungstag und Bekanntmachung des Hinweises auf die Patenterteilung: **08.05.2019**
(21) Anmeldenummer: 10730382.8
(22) Anmeldetag: 29.06.2010
(51) Int. Cl.: H05K 1/02, H05K 1/03

(54) **VERFAHREN ZUR ERZEUGUNG EINES ELEKTRONISCHEN SYSTEMS, VERFAHREN ZUR ERZEUGUNG EINER FREIFORMFLÄCHE MIT EINEM SOLCHEN SYSTEM, SOWIE ELEKTRONISCHES SYSTEM UND FREIFORMFLÄCHEN MIT EINEM SOLCHEN SYSTEM**
PRODUCTION METHOD FOR AN ELECTRONIC SYSTEM, PRODUCTION METHOD FOR A FREE FORMING SURFACE INCLUDING SUCH A SYSTEM, CORRESPONDING ELECTRONIC SYTEM AND FREE FORMING SURFACE INCLUDING SUCH A SYSTEM
PROCÉDÉ DE FABRICATION D'UNE SYSTÈME ÉLECTRONIQUE, PROCÉDÉ DE FABRICATION D'UNE SURFACE FLEXIBLE AYENT UN TEL SYSTÈME, SYSTÈME ÉLECTRONIQUE CORRESPONDANT

(30) Priorität: 29.06.2009 DE 102009031568
(43) Veröffentlichungstag der Anmeldung: 09.05.2012
(73) Patentinhaber: Fraunhofer-Gesellschaft zur Förderung der angewandten Forschung e.V., 80686 München (DE); Technische Universität Berlin, 10623 Berlin (DE)
(72) Erfinder: LÖHER, Thomas, 10961 Berlin (DE); OSTMANN, Andreas, 10585 Berlin (DE); SECKEL, Manuel, 10559 Berlin (DE)
(74) Vertreter: Pfenning, Meinig & Partner mbB
(86) Internationale Anmeldenummer: PCT/EP2010/004099
(87) Internationale Veröffentlichungsnummer: WO 2011/000580

(56) Entgegenhaltungen:
- EP-A2- 1 926 355
- WO-A1-2005/031550
- WO-A1-2008/152575
- GB-A- 2 261 290
- US-A- 3 340 608
- US-A1- 2004 224 138
- US-A1- 2004 243 204
- US-A1- 2005 280 157
- US-A1- 2007 053 179
- US-A1- 2008 157 235

## Beschreibung

Die Erfindung betrifft ein Verfahren zur Erzeugung eines elektronischen Systems zur Aufbringung auf Freiformflächen, ein Verfahren zur Herstellung von Freiformflächen mit einem elektronischen System sowie ein elektronisches System und eine Kombination einer Freiformfläche mit mindestens einen solchen System.

Das wichtigste Anwendungsgebiet derartiger elektronischer Systeme ist die textile Elektronik. Nach dem Stand der Technik ist es bekannt Schaltungsträger auf Textilien, wie beispielsweise Kleidungsstücken, zu befestigen. Hierbei beeinflussen sie jedoch zumeist die Eigenschaften der Textilien in negativer Weise. Beispielsweise verringern auf Kleidungsstücke aufgebrachte elektronische Systeme den Tragekomfort der Kleidung.

Aus US 2004/0224138 A1 ist ein Verfahren zur Herstellung eines Textilartikels bekannt, wobei der Textilartikel einen elektronischen Schaltkreis mit flexiblem, biegsamem Schaltungsträger umfasst.

Aus EP 1 926 355 A2 ist ein Verfahren zur Herstellung eines entlang einer Ausgangslänge dehnbaren Schaltungsträgers bekannt, wobei die Dehnbarkeit erreicht wird durch Verwendung eines dehnbaren Substrats und einer wellenförmig ausgebildeten Leiterbahn.

Nach dem Stand der Technik werden elektronische Systeme zur Aufbringung auf Freiformflächen gefertigt, indem auf ein Substrat eine Kontaktstruktur und anschließend elektronische Komponenten aufgebracht werden. Freiformflächen mit elektronischen Systemen werden gefertigt, in dem so hergestellte elektronische Systeme aufgeklebt oder aufgestickt und anschließend verkapselt werden.

Nach dem Stand der Technik können nur Freiformflächen mit elektronischen Systemen bestückt werden, die in maximal einer Raumrichtung gekrümmt sind. Dies beschränkt im Bezug auf starre Freiformflächen das Einsatzgebiet, da ein Aufbringen auf in mehrere Raumrichtungen gekrümmte starre Freiformflächen nicht möglich ist. In Bezug auf flexible Freiformflächen, wie beispielsweise textile Träger, führt dies dazu, dass nach dem bestücken des textilen Trägers dieser nur noch in eine Raumrichtung gekrümmt werden kann.

Der Erfindung liegt also die Aufgabe zu Grunde, ein Verfahren zur Erzeugung eines elektronischen Systems zu entwickeln, wobei sich das erzeugte elektronische System auf beliebig geformte Freiformflächen aufbringen lassen soll. Eine weitere Aufgabe der Erfindung ist es, ein elektronisches Systeme vorzuschlagen, das bei Aufbringung auf textile Träger, insbesondere Kleidungsstücken, den Tragekomfort nicht oder nur unwesentlich reduziert. Eine weitere Aufgabe ist es, das Aufbringen auf die Freiformfläche möglichst einfach zu ermöglichen.

Die Aufgabe wird durch die Verfahren nach Anspruch 1 sowie nach Anspruch 2, durch ein elektronisches System nach Anspruch 7 und eine Freiformfläche mit mindestens einen elektronischen System nach Anspruch 13 gelöst.

Vorteilhafte Weiterbildungen werden in den abhängigen Ansprüchen genannt.

Das erfindungsgemäße Verfahren sieht vor, dass zunächst ein dehnbares Substrat, welches zumindest zum überwiegenden Teil aus dehnbarem Material besteht, bereitgestellt wird, wobei auf oder in dieses Substrat eine dehnbare auffächernde Kontaktstruktur mit Kontaktflächen aufgebracht bzw. eingearbeitet wird. Auf den so erzeugten Schaltungsträger, welcher auch als Interposer bezeichnet wird, werden anschließend elektronische Bauteile aufgebracht. Hierbei können beliebige elektronische Komponenten montiert werden. Nach dem Aufbringen der elektronischen Bauteile wird der nun vorliegende Schaltungsträger mit einem dehnbaren Material verkapselt. Mit Verkapseln ist hier gemeint, dass zumindest auf die elektronischen Komponenten sowie einen auffächernden Bereich der Kontaktstruktur (die Kontaktflächen können optional von der Verkapselung ausgenommen sein) ein dehnbares Material aufgebracht wird.

Durch dieses erfindungsgemäße Herstellungsverfahren werden elektronische Systeme erzeugt, die überwiegend dehnbar sind und sich somit auch auf mehrdimensionale Freiformflächen aufbringen lassen, wobei die Eigenschaften der Freiformfläche, wie zum Beispiel die Verformbarkeit, Dehnbarkeit und Beweglichkeit, nur geringfügig oder gar nicht negativ beeinflusst werden. Ein so hergestelltes elektronisches System ist beispielsweise dafür geeignet, auf ein Kleidungsstück aufgebracht zu werden, wobei der Tragekomfort nur minimal reduziert wird. Dadurch, dass die Kontaktstruktur als auffächernde Kontaktstruktur ausgebildet ist, ist es ohne Verlust an Zuverlässigkeit möglich, nah beieinander liegende Kontakte der elektronischen Bauteile mit gröberen Mitteln zur Kontaktierung, wie beispielsweise leitfähigen Garnen, zu verbinden. So sind durch dieses Herstellungsverfahren hergestellte elektronische Systeme dazu geeignet, mit solchen Mitteln miteinander verbunden zu werden.

Durch die Dehnbarkeit des elektronischen Systems wird für einige starre Freiformflächen die Ausstattung mit elektronischen Systemen erst möglich. Für nicht starre Freiformflächen ergibt sich der Vorteil, dass eine Dehnbarkeit und Biegbarkeit der Freiformfläche nur unwesentlich durch das elektronische System verringert wird.

In einer vorteilhaften Ausführungsform der Erfindung sind der Schaltungsträger und/oder das Verkapselungsmaterial geschlossen, d.h. ohne zu den elektronischen Bauteilen führende Öffnungen, ausgebildet. Solche Öffnungen, wie sie bei textilen Trägern grundsätzlich aufgrund einer Gewebestruktur vorhanden sind, sind beispielsweise hinsichtlich einer Waschbarkeit des elektronischen Systems nachteilig. Eine ohne Öffnungen aufgebrachte hermetische Verkapselung, die insbesondere folienartig und fluiddicht ausgebildet sein kann, ermöglicht hingegen eine Waschbarkeit des elektronischen Systems.

Ebenso vorteilhaft kann der Schaltungsträger und/oder das Verkapselungsmaterial homogen dehnbar ausgebildet sein.

Vorteilhaft kann es sich bei der Freiformfläche um einen beweglichen Träger, wie beispielsweise einen textilen oder filzartigen Träger oder eine Folie, oder um eine starre Freiformfläche handeln.

Das Substrat und/oder die Verkapselung können bevorzugt aus einem Polymer und besonders bevorzugt aus einem Elastomer bestehen. Besonders bevorzugt kann das Substrat aus demselben Material wie die Verkapselung bestehen. Ebenso ist es möglich, dass das Substrat zwar nicht aus demselben Material wie die Verkapselung besteht, dass jedoch zumindest einige mechanische Materialparamter des Substratmaterials und des Verkapselungsmaterials identisch sind. Besonders bevorzugt ist zumindest der Elastizitätsmodul und/oder der Wärmeausdehnungskoeffizient identisch. Hierdurch wird erreicht, dass auch durch häufiges Biegen sowie durch häufiges Erwärmen und Abkühlen keine Schäden entstehen.

Das Aufbringen auf die Freiformfläche kann insbesondere durch Kleben, Laminieren, Nieten oder Sticken geschehen.

Zum Erleichtern des Aufbringens ist es besonders vorteilhaft, wenn das Substrat und/oder die Verkapselung aus einem thermoplastischen Material und besonders bevorzugt aus einem thermoplastischen Elastomer besteht, da es hierdurch ermöglicht wird zum Aufbringen des elektronischen Systems, entweder das elektronische System oder die Freiformfläche auf eine Temperatur zu erhitzen, bei der das thermoplastische Material selbstklebende Eigenschaften hat. Das elektronische System wird dann auf die Freiformfläche aufgedrückt und so mit dieser verbunden. Auf diese Art kann das elektronische System auf eine Freiformfläche aufgebracht werden, wobei keine weitere Klebeschicht notwendig ist.

Dies kann entweder auf vorteilhaft einfache Weise bei der Herstellung einer Freiformfläche mit einem aufgebrachten elektronischen System am Ort der Herstellung geschehen oder dem Endnutzer überlassen werden.

Letzteres ist ganz besonders vorteilhaft, denn so kann sich ein Nutzer verschiedene elektronische Systeme aussuchen, die fertig verkapselt geliefert werden und diese dann selbst, beispielsweise durch Aufbügeln, auf ein Kleidungsstück seiner Wahl aufbringen. So ist der Nutzer nicht auf bestimmte von einem Hersteller bereitgestellte Kombinationen aus elektronischen Systemen und Freiformflächen beschränkt, sondern kann elektronische Systeme und Freiformflächen frei kombinieren. Ein nutzerseitiges Aufbringen des elektronischen Systems ist selbstverständlich nicht nur bei flexiblen Freiformflächen, sondern genauso auch bei starren Freiformflächen möglich. So kann ein Nutzer auf einfache Weise ein fertig fabriziertes und vorzugsweise bereits getestetes elektronisches System auf eine starre Freiformfläche, beispielsweise im Auto, aufbringen.

Vorteilhaft ist es, wenn das Aufbringen bei einer Temperatur zwischen 100°C und 200°C besonders vorteilhaft 120°C bis 180°C insbesondere 150°C geschehen kann, denn solche Temperaturen sind für die meisten Freiformflächen, insbesondere für Kleidungsstücke, unschädlich.

In einem bevorzugten Ausführungsbeispiel wird nach dem Aufbringen des elektronischen Systems auf die Freiformfläche die mindestens eine Kontaktfläche mit leitfähigen Garnen, gekapselten Leiterbahnen, Drähten oder dergleichen verbunden. Hierzu sollten die Kontaktflächen zur Kontaktierung durch Löt-, Schweiß-, Druckknopf- oder Stickkontakte geeignet ausgebildet werden. Als Stickkontakte werden hier Kontaktflächen bezeichnet, die mit einer Nadel durchstochen werden können. Bei einer Ausbildung der Kontaktflächen als Stickkontakte kann es vorteilhaft sein, auch die Stickkontakte mit zu verkapseln. Beispielsweise können die Kontaktflächen die Form von Druckknöpfen haben so dass sie mit einem entsprechenden Gegenstück kontaktiert werden können. Eine zur Kontaktierung durch Stickkontakte ausgebildete Kontaktfläche könnte beispielsweise perforiert und/oder sehr dünn ausgebildet sein, so das ein durchstechen möglich ist. Durch derart einfache Kontaktierungsmöglichkeiten ist es besonders einfach, mehrere elektronische Systeme auf eine Freiformfläche aufzubringen und diese miteinander zu verbinden.

In dem Fall, dass mehrere elektronische Bauteile auf ein Substrat aufgebracht werden sollen, ist es vorteilhaft, diese als Komponentencluster mit möglichst geringem Abstand zueinander, vorteilhaft ungefähr mittig auf dem Substrat, aufzubringen. Dadurch sind nur auf einem kleinen Teil einer Gesamtfläche des Substrates elektronische Bauteile angeordnet, so dass die Dehnbarkeit und Biegsamkeit des Substrates nur in einem kleinen Gebiet durch elektronische Bauteile reduziert wird, während die restliche Fläche für die dehnbare auffächernde Kontaktstruktur zur Verfügung steht.

Ein besonders guter Schutz gegen mechanische Beanspruchung des elektronischen Systems wird erreicht, wenn zumindest die Fläche des Substrats mit den Leiterbahnen der Kontaktstruktur und dem mindestens einen elektronischen Bauteil verkapselt wird. Dabei können die Kontaktflächen frei gelassen werden, damit die Verkapselung nicht die Kontaktierung des elektronischen Systems erschwert.

Die Verkapselung und/oder das Substrat werden vorzugsweise aus einem Elastomer bzw. thermoplastischen Elastomer und besonders vorzugsweise aus Polyurethan, Silikon, Kautschuk, Latex oder dergleichen gefertigt, da diese Materialien aufgrund ihrer Dehnbarkeit besonders geeignet sind.

Der Elastizitätsmodul des verwendeten Materials ist vorteilhaft kleiner als 0,2 GPa. Besonders vorteilhaft ist ein Elastizitätsmodul kleiner als 0,02GPa. Insbesondere kann der Elastizitätsmodul zwischen 0,006 und 0,01 GPa liegen. Hierdurch wird eine besonders gute Dehnbarkeit und somit ein besonders hoher Tragekomfort erreicht.

Es können verschiedenste elektronische Bauteile verwendet werden. MEMs, Chips, modularisierte Subsysteme, Speichermedien sowie Sende und Empfangsvorrichtungen sind nur einige von vielen Möglichkeiten. Diese können beispielsweise durch Löten oder Kleben mit der Kontaktstruktur verbunden werden. Hierzu ist es hilfreich, zuvor eine Maske zur Lot- oder Klebebegrenzung aufzubringen.

In einem bevorzugten Ausführungsbeispiel wird die auffächernde Kontaktstruktur durch Leiterbahnen gebildet, die entsprechend dem Funktionsprinzip einer Feder geformt sind, d.h. wird die Leiterbahn in Richtung ihrer Hauptrichtung gedehnt, so nimmt die Gesamtlänge der Leiterbahn nur unwesentlich zu, so dass durch diese Dehnung keine Beschädigung der Leiterbahn erfolgt. Beispielsweise können die Leiterbahnen alternierend in einander gegenüberliegende Richtungen aus einer Hauptrichtung gekrümmt sein, wie dies beispielsweise bei einer wellen-, zickzack- oder mäanderförmigen Ausformung der Leiterbahnen gegeben ist. Dabei kann die Dicke der Leiterbahnen konstant sein, aber sich auch kontinuierlich oder sprunghaft von dem elektronischen Bauteil zur Kontaktfläche ändern.

Insbesondere bei einer alternierend in einander gegenüberliegende Richtungen aus einer Hauptrichtung gekrümmten Ausbildung der Leiterbahnen kann ein Leiterbahnquerschnitt zumindest einiger Leiterbahnen kleiner als 1 mm² und besonders vorzugsweise kleiner als 0,5 mm² oder 0,1 mm² sein. Besonders bevorzugt können sogar Strukturgrößen von 100 µm bzw. Kontaktabstände von 200 µm ermöglicht werden. Durch derart kleine Strukturgrößen ist es möglich, Kontaktierungspunkte von elektronischen Bauteilen nah beieinander anzuordnen. Hierdurch können die elektronischen Komponenten zusammen in einem kleinen Teilbereich des elektronischen Systems verbaut werden. Der Bereich des elektronischen Systems, in dem die Dehnbarkeit durch elektronische Bauteile reduziert ist, kann daher sehr klein sein.

In einer weiteren vorteilhaften Ausführungsform sind die Leiterbahnen aus einem homogen leitfähigen Material ausgebildet, d.h. eine Leitfähigkeit des leitfähigen Materials ist vorzugsweise nicht durch leitfähige Partikel, die in einer nichtleitenden Matrix eingebettet sind, gegeben. Besonders vorteilhaft können die Leiterbahnen als metallische Leiterbahnen ausgebildet sein. Als metallische Leiterbahnen werden dabei Leiterbahnen aufgefasst, die zumindest überwiegend und möglichst vollständig aus Metall bestehen. Leiterbahnen aus metallhaltigen Klebstoffen werden nicht als metallische Leiterbahnen im Sinne der Erfindung angesehen.

Ein spezifischer Widerstand des Materials, aus dem die Leiterbahnen bestehen ist vorzugsweise kleiner als 10 Ω mm²/m und besonders vorzugsweise kleiner als 2 Ω mm²/m, 1 Ω mm²/m oder sogar kleiner als 0,1 Ω mm²/m oder 0,02 Ω mm²/m. Hierdurch wird ein sehr geringer Spannungsabfall an den Leiterbahnen erreicht.

Beispielsweise durch eine Ausbildung von Substrat, Verkapselung und Leiterbahnen, wie vorangehend beschrieben, lässt sich ein elektronisches System erzeugen, das sich über 10.000 mal um bis zu mindestens 1%, vorzugsweise über 20.000 mal um bis zu mindestens 2% und besonders vorzugsweise über 30.000 mal oder sogar etwa 50.000 mal bis zu mindestens 2,5% dehnen lässt, ohne dass ein Ausfall des elektronischen Systems erfolgt. Vorzugsweise ist es sogar mindestens einmal möglich, das elektronische System um bis zu mindestens 50%, vorzugsweise mindestens 80% oder mindestens 300%, zu dehnen, ohne dass ein Ausfall des elektronischen Systems erfolgt.
Im Folgenden werden die erfindungsgemäßen Verfahren sowie das erfindungsgemäße elektronische System und die erfindungsgemäße Freiformfläche anhand einiger Ausführungsbeispiele genauer erläutert. Es zeigen
- Fig. 1a bis 1g: Aufsicht sowie Seitenansicht verschiedener Schritte des erfindungsgemäßen Verfahrens zur Erzeugung eines dehnbaren elektronischen Systems und eines Textils mit einem solchen System,
- Fig. 2: Textilstück mit mehreren aufgebrachten erfindungsgemäßen elektronischen Systemen,
- Fig. 3: erfindungsgemäß mit einem elektronischen System ausgestattete kugelförmige starre Freiformfläche,
- Fig. 4: Folie mit einem erfindungsgemäßen elektronischen System,
- Fig. 5: Seitenansichten sowie Aufsicht weiterer Ausführungsformen eines erfindungsgemäßen Systems,
- Fig. 6: Schnittansicht einer weiteren Ausführungsform eines erfindungsgemäßen Systems.

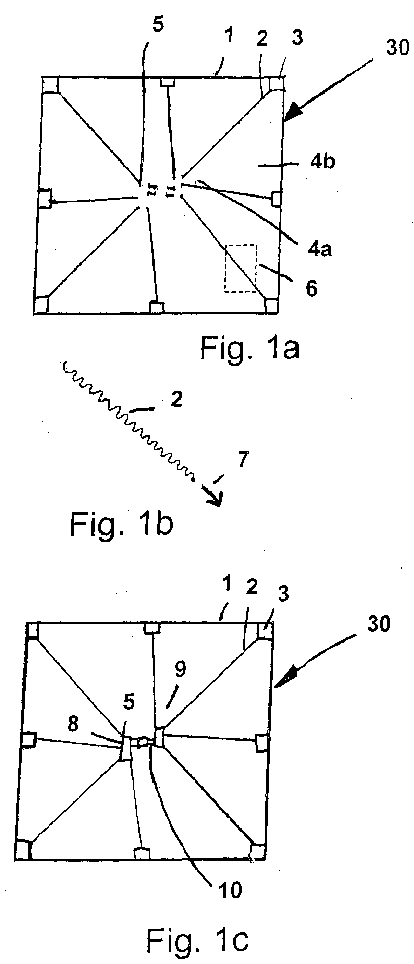

Figur 1a zeigt einen im ersten Verfahrensschritt bereitgestellten Schaltungsträger 30. Dieser besteht aus einem dehnbaren Substrat 1, welches aus einem thermoplastischen Polyurethan hergestellt ist. Auf dieses ist eine Kontaktstruktur aufgebracht, die aus mehreren Leiterbahnen 2 sowie Kontaktflächen 3 und Kontaktstellen 5 zusammengesetzt ist. Die Kontaktstruktur kann mittels üblicher Leiterplattentechnik, vorzugsweise Subtraktivtechnik, erstellt werden. Hierbei kann mindestens ein Ätzschritt vorgesehen sein. Die Leiterbahnen 2, die zwischen den Kontaktstellen 5 und Kontaktflächen 3 angeordnet sind, sind derart ausgebildet, dass in der Nähe der Kontaktstellen 5 der Abstand 4a zwischen ihnen deutlich kleiner ist als ein Abstand 4b in der Nähe der Kontaktflächen 3, die im Ausführungsbeispiel am Rand des Substrates angeordnet sind und die im Verhältnis zu den Kontaktstellen 5 relativ groß sind und daher leicht von außen kontaktiert werden können. Ein Ausschnitt 6 des Schaltungsträgers 30 ist in Fig. 1b stark vergrößert dargestellt. Hier ist zu erkennen, dass die Leiterbahn 2 wellenförmig ausgebildet ist und alternierend in einander gegenüber liegende Richtungen aus einer Hauptrichtung 7 heraus gekrümmt ist. Hierdurch wird erreicht, dass die Leiterbahn 2 sehr flexibel und dehnbar ist.

In Fig. 1c ist der Schaltungsträger 30 nach dem zweiten Verfahrensschritt gezeigt. Dabei sind inzwischen elektronische Bauteile 8 aufgebracht und beispielsweise durch Löten mit den Kontaktstellen 5 elektrisch verbunden. Eine andere Möglichkeit ist, die elektronischen Bauteile bzw. deren Kontaktstellen mit einem leitfähigen Klebstoff, wie z.B. kupfer- oder silberhaltigem Epoxidharzkleber, aufzukleben. Vor dem Bestücken mit elektronischen Komponenten wird üblicherweise eine Lötstoppmaske auf das Substrat aufgebracht, die jedoch nicht mit abgebildet ist. Das Bestücken mit den elektronischen Bauteilen kann bevorzugt automatisch, d.h. maschinell erfolgen. Die elektronischen Bauteile sind als Cluster 9 angeordnet, d.h. der Abstand 10 zwischen den Komponenten ist relativ klein. Damit ist gemeint, dass der Abstand zwischen zwei benachbarten elektronischen Bauteilen in der selben Größenordnung wie der Abstand zwischen zwei Kontakten des gleichen Bauteils, zumindest jedoch eine Größenordnung kleiner als der Abstand zweier benachbarter peripherer Kontaktflächen 3 ist.

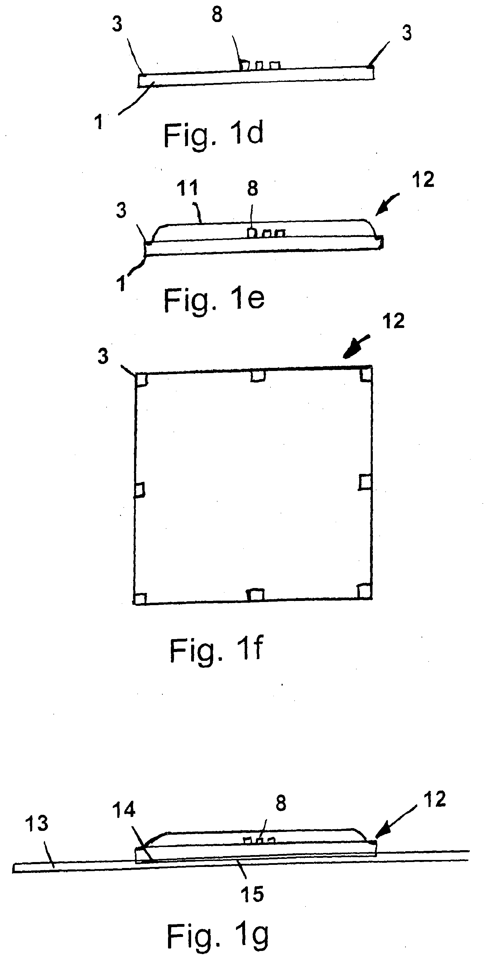

In Fig. 1d ist der Schaltungsträger 30 mit Substrat 1, Kontaktflächen 3 und elektronischen Bauteilen 8 in der Seitenansicht dargestellt.

Fig. 1e zeigt das fertige elektronische System 12 in der Seitenansicht. Eine Verkapselung 11, die die elektronischen Bauteile 8 vollständig umschließt und die Leiterbahnen der Kontaktstruktur überdeckt, wurde durch ein Spritzgussverfahren aufgebracht. Die Verkapselung 11 besteht aus Polyurethan und ist daher sehr dehnbar. Das für die Verkapselung verwendete Polyurethan ist nicht thermoplastisch.

Fig. 1f zeigt ebenfalls das fertige elektronische System, jedoch in der Aufsicht. Lediglich die Kontaktflächen 3 liegen noch frei. Alles andere ist unter der Verkapselung 11 verborgen und somit nicht mehr sichtbar. Dieses elektronische System kann als selbstklebendes (bei circa 150°C) Fan-out Package bezeichnet werden.

In Fig. 1g ist eine Freiformfläche 13 mit dem in Fig. 1e gezeigten elektronischen System 12 dargestellt. In diesem Ausführungsbeispiel ist die Freiformfläche als Textilstück 13 ausgebildet. Das elektronische System 12 wurde in einer Kleidungslaminierpresse auf 150°C erhitzt und auf das Textilstück 13 aufgedrückt. Die Oberseite 14 des Textilstücks wurde hierdurch in die Unterseite 15 des elektronischen Systems hineingedrückt. Hierdurch entsteht eine sehr stabile Verbindung. Gleiches geschieht bei Verwendung einer filzartigen Freiformfläche.

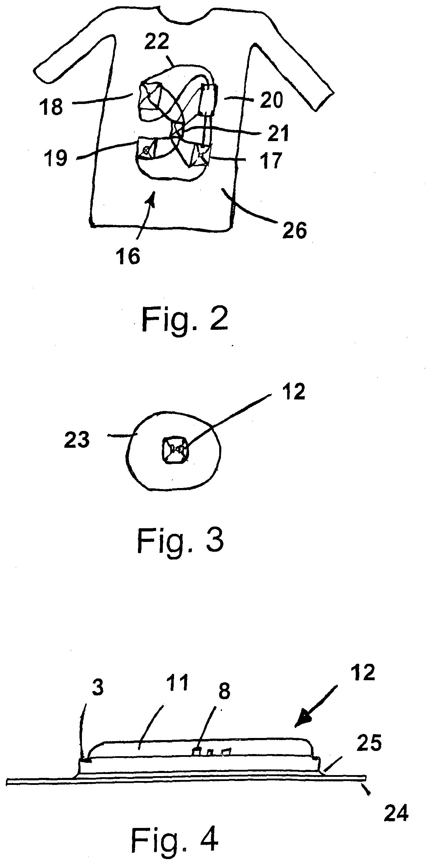

Fig. 2 zeigt ein Kleidungsstück 26 mit einer aufgebrachten Alarmvorrichtung 16. Hiermit können beispielsweise hilflose Personen ausgestattet werden. Auf dem Kleidungsstück sind eine Sende- und Empfangsvorrichtung 17, akustische 18 und optische Ausgabemittel 19, ein Speichermedium 20, sowie eine Energieversorgung 21 enthaltende dehnbare elektronische Systeme aufgestickt, die modularisierte Subsysteme der Alarmvorrichtung sind. Auch eine Aufbringung der elektronischen Systeme durch Nieten, Laminieren oder Kleben wäre denkbar. Im Ausführungsbeispiel sind die elektronischen Systeme durch leitfähiges Garn 22 miteinander verbunden. Die Sende- und Empfangsvorrichtung 17 kann beispielsweise zur Kommunikation mit einer nicht gezeigten Basisstation ausgebildet sein, wodurch Signale empfangen und gesendet und gegebenenfalls akustische und optische Notsignale ausgelöst werden können. Aufgrund der Verwendung der dehnbaren elektronischen Systeme 12 ist das Kleidungsstück komfortabel zu tragen, da es flexibel und dehnbar bleibt. Die Dehnbarkeit ist hier lediglich durch die elektronischen Bauteile geringfügig eingeschränkt. Die auffächernden Kontaktstrukturen, die einen deutlich größeren Flächenanteil des Kleidungsstücks einnehmen, sind jedoch dehnbar und beeinträchtigen den Komfort nicht.

Fig. 3 zeigt ein Beispiel für eine starre Freiformfläche mit einem aufgebrachten elektronischen System 12. Die starre Freiformfläche ist hierbei in Form einer Kugel 23 ausgebildet. Nur durch die Dehnbarkeit des elektronischen Systems 12 ist ein Aufbringen auf eine als Kugel geformte Freiformfläche möglich. Flexible, aber nicht dehnbare elektronische Systeme 12 könnten lediglich auf in eine Raumrichtung gekrümmte Objekte, wie beispielsweise zylinderförmige Objekte, aufgebracht werden. Eine Krümmung in zwei Raumrichtungen ist immer mit einer Dehnung verbunden.

In Figur 4 ist ein auf eine Folie 24 aufgebrachtes elektronisches System 12 dargestellt. Das elektronische System 12 ist durch eine Klebeverbindung 25 fest mit der Folie 24 verbunden. Bei der Folie handelt es sich um eine Klebefolie. Durch die Aufbringung des dehnbaren elektronischen Systems auf eine Klebefolie kann es auf eine beliebig geformte Fläche aufgeklebt werden.

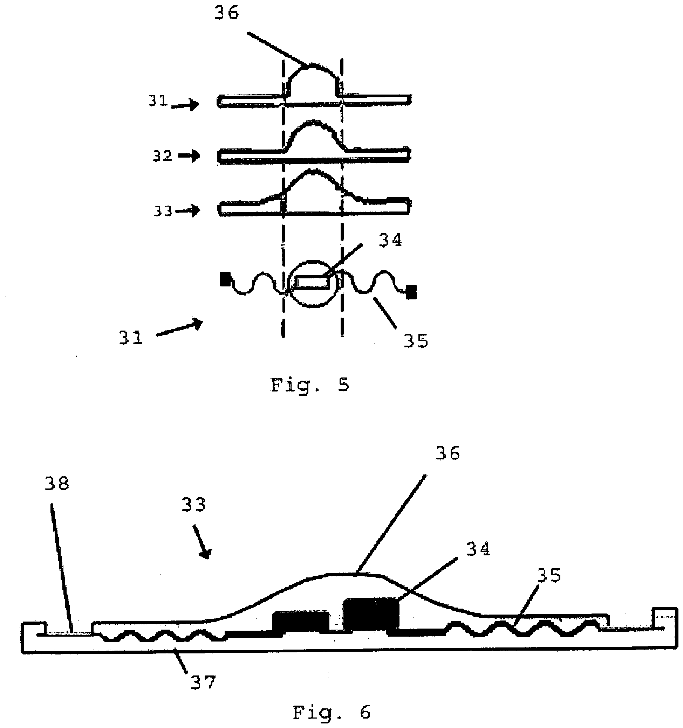

In Figur 5 sind weitere Ausführungsformen von elektronischen Systemen 31, 32 und 33 in Seitenansicht dargestellt. Eine Aufsicht auf das elektronische System 31 ist unten in Figur 5 gezeigt. Die elektronischen Systeme 31, 32, 33 weisen einen kontinuierlichen Übergang zwischen einem erhöhten mittleren Bereich 36, in dem ein Verkapselungsmaterial mit erhöhter Dicke zum Abdecken der elektronischen Komponente 34 aufgebracht ist, und einem äußeren Bereich, in dem das Verkapselungsmaterial die Leiterbahnen 35 abdeckt, auf. Hierdurch wird besonders zuverlässig eine Beschädigung des elektronischen Systems beim Dehnen desselben vermieden, denn eine Dehnbarkeit ist aufgrund der erhöhten Dicke der Verkapselung im Bereich der elektronischen Komponenten reduziert, während die Verkapselung im äußeren Bereich (d.h. über den Leiterbahnen der Kontaktstruktur) vorzugsweise weniger als 200 µm und besonders bevorzugt zwischen 50 µm und 100 µm dick ausgebildet ist, sodass das elektronische System im äußeren Bereich besonders gut dehnbar ist.

Die elektronischen Systeme 31, 32, 33 unterscheiden sich jeweils in einer Härte des Übergangs zwischen dem erhöhten mittleren Bereich 36 und dem äußeren Bereich. Dieser Übergang ist in dem elektronischen System 31 am härtesten, d.h. mit der größten Ortsableitung der Dicke ausgebildet, während die Übergänge in den elektronischen Systemen 32 und 33 sukzessive weicher sind. Bei Erstellung weiterer Ausführungsformen kann der Übergang fest-dehnbar frei modelliert und an die Anforderungen der jeweiligen Ausführungsform hinsichtlich Dehnbarkeit und mechanischer Stabilität im Bereich der elektronischen Komponenten angepasst, d.h. kontrolliert eingestellt werden.

Genauer dargestellt ist das elektronische System 33 in der in Fig. 6 gezeigten Schnittansicht. Die Unterseite des elektronischen Systems wird durch das Substrat 37 gebildet. Darauf aufgebracht sind strukturierte Leiterbahnen 35, die zur Verdeutlichung mit einer wellenförmigen Struktur dargestellt sind, obwohl die Wellen eigentlich nicht, wie in Figur 6 dargestellt, in der Zeichenebene, sondern orthogonal zu dieser verlaufen. Außen befinden sich Kontaktflächen 38, während in etwa mittig auf dem Substrat 37 elektronische Komponenten 34 angeordnet sind. Es sei erwähnt, dass ein Verfahren d.h. die Prozessschritte zur Herstellung eines elektronischen Systems mit einem kontinuierlichen Übergang zwischen einem erhöhten mittleren Bereich 36 und einem äußeren Bereich, wie es in den Fign. 5 und 6 dargestellt ist, bzw. einer Freiformfläche mit einem solchen elektronischen System, genauso ablaufen kann wie dies bezüglich der Fign. 1a bis 1g erläutert ist, d.h. jegliche Merkmale die im Zusammenhang mit den Figuren 1a bis 1g erwähnt werden, können auch in Bezug auf elektronische Systeme 33 wie in Figur 6 gezeigt vorteilhaft sein.

Lediglich die Ausbildung des Verkapselungsmaterials unterscheidet sich zu den Figuren 1e und 1g dahingehend, dass ein Übergang zwischen einem erhöhten mittleren Bereich 36 und einem äußeren Bereich kontinuierlich ist.

Anders als in Figur 1f sind bei der Ausführungsform nach Fig. 6 die Kontaktflächen vom Rand des Systems 33 geringfügig beabstandet angeordnet, wodurch ein versehentliches seitliches Kontaktieren verhindert wird. Das fertige elektronische System ist, wie in Figur 6 dargestellt, anstatt wie in Figur 1e gezeigt, ausgebildet. Selbstverständlich kann ein elektronisches System 33 wie es in Figur 6 dargestellt ist auch auf eine Folie 24, wie in Figur 4 gezeigt, aufgebracht werden.

## Patentansprüche

1. Verfahren zur Erzeugung eines dehnbaren elektronischen Systems zur Aufbringung auf Freiformflächen (13) mit folgenden Schritten:
- Bereitstellen eines dehnbaren Interposers mit einem dehnbaren Substrat (1), einer aus Leiterbahnen (2) bestehenden dehnbaren auffächernden Kontaktstruktur mit Kontaktstellen (5) und am Rand des Substrats (1) angeordneten peripheren Kontaktflächen (3), wobei die Leiterbahnen (2) zwischen den Kontaktstellen (5) und den Kontaktflächen (3) angeordnet sind,
- Aufbringen mindestens einer elektronischen Komponente (8) auf den Interposer und Verbinden der elektronischen Komponente (8) mit den Kontaktstellen (5),
- Verkapseln mit einem dehnbaren Material, wobei die Leiterbahnen derart ausgebildet sind, dass in der Nähe der Kontaktstellen (5) ein Abstand (4a) zwischen den Leiterbahnen deutlich kleiner ist als ein Abstand (4b) in der Nähe der Kontaktflächen (3).

2. Verfahren zur Erzeugung einer Freiformfläche (13) mit einem dehnbaren elektronischen System mit folgenden Schritten:
- Bereitstellen des mittels des Verfahrens gemäss Anspruch 1 erzeugten dehnbaren elektronischen Systems,
- Bereitstellen einer Freiformfläche (13),
- Aufbringen des zuvor verkapselten dehnbaren elektronischen Systems auf die Freiformfläche (13).

3. Verfahren nach Anspruch 2 , **dadurch gekennzeichnet, dass** der zuvor verkapselte Schaltungsträger (30) auf die Freiformfläche (13) durch Kleben, Laminieren, Nieten oder Sticken aufgebracht wird.

4. Verfahren nach Anspruch 3, **dadurch gekennzeichnet, dass** beim Aufbringen des dehnbaren elektrischen Systems die Freiformfläche (13) oder das dehnbare elektrische System erwärmt werden.

5. Verfahren nach Anspruch 4, **dadurch gekennzeichnet, dass** die Freiformfläche oder das dehnbare elektrische System auf eine Temperatur zwischen 100°C und 200°C erwärmt wird.

6. Verfahren nach einem der Ansprüche 1 bis 5, **dadurch gekennzeichnet, dass** zumindest die Fläche des Substrats (1) mit den Leiterbahnen (2) der Kontaktstruktur und dem mindestens einen elektronischen Bauteil (8) verkapselt wird.

7. Dehnbares elektronisches System zur Aufbringung auf einen Freiformträger, hergestellt durch ein Verfahren gemäß einem der Ansprüche 1 oder 6, wobei das dehnbare elektronische System einen dehnbaren Interposer mit einem dehnbares Substrat (1) und einer aus Kontaktstellen (5), am Rand des Substrats angeordneten peripheren Kontaktflächen (3) und zwischen den Kontaktflächen (3) und Kontaktstellen (5) angeordneten Leiterbahnen bestehende Kontaktstruktur, sowie eine dehnbare Verkapselung (11) und mindestens ein elektronisches Bauteil (8) aufweist das mit den Kontaktstellen (5) elektrisch verbunden ist, wobei die Kontaktstruktur als dehnbare auffächernde Kontaktstruktur ausgebildet ist und die Leiterbahnen (2) in am Rand des Schaltungsträgers (30) angeordneten Kontaktflächen (3) enden, wobei die Leiterbahnen derart ausgebildet sind, dass in der Nähe der Kontaktstellen (5) ein Abstand (4a) zwischen den Leiterbahnen deutlich kleiner ist als ein Abstand (4b) in der Nähe der Kontaktflächen (3).

8. Dehnbares elektronisches System nach Anspruch 7, **dadurch gekennzeichnet, dass** die mindestens eine elektronische Komponente ein Subsystem, Chip, MEMS oder ähnliches ist.

9. Dehnbares elektronisches System nach Anspruch 7 oder 8, **dadurch gekennzeichnet, dass** mindestens eine Kontaktfläche (3) als Druckknopfkontakt oder Stickkontakt ausgebildet ist.

10. Dehnbares elektronisches System nach einem der Ansprüche 7 bis 9, **dadurch gekennzeichnet, dass** die Leiterbahnen (2) als alternierend in einander gegenüberliegende Richtungen aus einer Hauptrichtung gekrümmten Leiterbahnen (2) ausgebildet sind.

11. Dehnbares elektronisches System nach einem der Ansprüche 7 bis 10, **dadurch gekennzeichnet, dass** das für die Verkapselung (11) verwendete dehnbare Material und/oder das Material des Substrates (1) ein Elastizitätsmodul kleiner als 0,2 GPa aufweist.

12. Dehnbares elektronisches System nach einem der Ansprüche 7 bis 11, **dadurch gekennzeichnet, dass** ein die Verkapselung (11) bildendes dehnbares Material oder ein den Großteil des Substrates (1) bildendes Material, ein thermoplastisches Material wie Polyurethan, Silikon, Kautschuk oder Latex ist.

13. Freiformfläche (13) mit mindestens einem dehnbaren elektronischen System nach einem der Ansprüche 7 bis 12, wobei das elektronische System fest auf die Freiformfläche (13) aufgebracht ist.

14. Freiformfläche (13) mit mindestens einem dehnbaren elektronischen System nach Anspruch 13, **dadurch gekennzeichnet, dass** die Freiformfläche (13) ein textiler oder filzartiger Träger, eine Folie (24) oder eine starre Freiformfläche (13) ist.

15. Freiformfläche (13) mit mindestens einem dehnbaren elektronischen System nach einem der Ansprüche 13 bis 14, **dadurch gekennzeichnet, dass** die Kontaktflächen (3) mit Mitteln zur Kontaktierung verbunden sind.

## Claims

1. A method for generating a stretchable electronic system for applying to freeform surfaces (13) comprising the following steps:
- providing a stretchable interposer having a stretchable substrate (1), a stretchable contact structure which comprises conductor tracks (2), fans out and has contact points (5) and peripheral contact surfaces (3), which are located at the margin of the substrate (1), wherein the conductor tracks (2) are arranged between the contact points (5) and the contact surfaces (3);
- applying at least one electronic component (8) to the interposer and connecting the electronic component (8) to the contact points (5); and
- encapsulating with a stretchable material;
wherein the conductor tracks are arranged such that a distance (4a) between the conductor tracks close to the contact points (5) is significantly smaller than a distance (4b) between the conductor trances close to the contact surfaces (3).

2. A method for generating a freeform surface (13) having a stretchable electronic system comprising the following steps:
- providing, by using the method in accordance with claim 1, the stretchable electronic system;
- providing a freeform surface (13); and
- applying the previously encapsulated stretchable electronic system onto the freeform surface (13).

3. A method in accordance with either of claims 2, **characterized in that** the previously encapsulated interconnect device (30) is applied to the freeform surface by bonding, laminating, riveting or stitching.

4. A method in accordance with claim 3, **characterized in that**, on the application of the stretchable electric system, the freeform surface (13) or the stretchable electric system is heated.

5. A method in accordance with claim 4, **characterized in that** the freeform surface or the stretchable electric system is heated to a temperature between 100°C and 200°C.

6. A method in accordance with one of the claims 1 to 5, **characterized in that** at least the surface of the substrate (1) is encapsulated with the conductor tracks (2) of the contact structure and the at least one electronic component (8).

7. A stretchable electronic system for applying to a freeform carrier, in particular manufactured by a method in accordance with one of the claims 1 to 6, wherein the stretchable electronic system comprises a stretchable interposer having a stretchable substrate (1) and a stretchable contact structure which comprises conductor tracks (2) and has contact points (5) and peripheral contact surfaces (3), which are located at the margin of the substrate (1), wherein the conductor tracks (2) are arranged between the contact points (5) and the contact surfaces (3); as well as a stretchable encapsulation, at least one electronic component (8) electronically connected to the contact points (5), wherein the contact structure is made as a stretchable contact structure which fans out and the conductor tracks (2) end in contact surfaces (3) arranged at the margin of the interconnect device (30);
wherein the conductor tracks are arranged such that a distance (4a) between the conductor tracks close to the contact points (5) is significantly smaller than a distance (4b) between the conductor trances close to the contact surfaces (3).

8. A stretchable electronic system in accordance with claim 7, **characterized in that** the at least one electronic component is a subsystem, chip, MEMS or similar.

9. A stretchable electronic system in accordance with claim 7, **characterized in that** at least one contact surface (3) is made as a press button contact or stitch contact.

10. A stretchable electronic system in accordance with one of the claims 7 to 9, **characterized in that** the conductor tracks (2) are made as conductor tracks (2) curved alternately in mutually disposed directions from a main direction.

11. A stretchable electronic system in accordance with one of the claims 7 to 10, **characterized in that** the stretchable material used for the encapsulation (11) and/or the material of the substrate (1) has a modulus of elasticity less than 0.02 GPa.

12. A stretchable electronic system in accordance with one of the claims 7 to 11, **characterized in that** a stretchable material forming the encapsulation (11) or a material forming a large part of the substrate (1) is a thermoplastic material such as polyurethane, silicone, rubber or latex.

13. A freeform surface (13) having at least one stretchable electronic system in accordance with one of the claims 7 to 12, wherein the electronic system is fixedly applied to the freeform surface (13).

14. A freeform surface (13) having at least one stretchable electronic system in accordance with claim 13, **characterized in that** the freeform surface (13) is a textile carrier, a felt-like carrier, a film (24) or a rigid freeform surface (13).

15. A freeform surface (13) having at least one stretchable electronic system in accordance with one of the claims 13 to 14, **characterized in that** the contact surfaces (3) are connected to means for contacting, in particular to conductive yarns, encapsulated conductor tracks or wires.

## Revendications

1. Procédé de production d'un système électronique élastique destiné à être appliqué sur des surfaces à formes libres (13), avec les étapes suivantes :
- préparation d'un intercalaire élastique avec un substrat élastique (1), une structure de contact élastique qui se déploie, constituée de pistes conductrices (2), avec des points de contact (5) et des surfaces de contact (3) périphériques disposées au bord du substrat (1), les pistes conductrices (2) étant disposées entre les points de contact (5) et les surfaces de contact (3),
- application d'au moins un composant électronique (8) sur l'intercalaire et liaison des composants électroniques (8) avec les points de contact (5),
- encapsulation avec un matériau élastique,
les pistes conductrices étant conçues de façon à ce que, à proximité des points de contact (5), une distance (4a) entre les pistes conductrices soit nettement inférieure à une distance (4b) à proximité des surfaces de contact (3).

2. Procédé de réalisation d'une surface à formes libres (13) avec un système électronique élastique, avec les étapes suivantes :
- préparation du système électronique élastique réalisé selon la revendication 1,
- préparation d'une surface à formes libres
- application du système électronique élastique encapsulé auparavant sur la surface à formes libres (13).

3. Procédé selon la revendication 2, **caractérisé en ce que** le support de circuit (30) encapsulé auparavant est appliqué sur la surface à formes libres (13) par collage, laminage, rivetage ou couture.

4. Procédé selon la revendication 3, **caractérisé en ce que**, lors de l'application du système électrique élastique, la surface à formes libres (13) ou le système électrique élastique est chauffé.

5. Procédé selon la revendication 4, **caractérisé en ce que** la surface à formes libres ou le système électrique élastique est chauffé à une température comprise entre 100°C et 200 °C.

6. Procédé selon l'une des revendications 1 à 5, **caractérisé en ce qu'**au moins la surface du substrat (1) est encapsulé avec les pistes conductrices (2) de la structure de contact et l'au moins un composant électronique (8).

7. Système électronique élastique destiné à être appliqué sur un support à formes libres, réalisé à l'aide d'un procédé selon l'une des revendications 1 ou 6, le système électronique élastique comprenant un intercalaire élastique avec un substrat élastique (1) et une structure de contact constituée de points de contact (5), de surfaces de contact (3) périphériques disposées au bord du substrat et de pistes conductrices disposées entre les surfaces de contact (3) et les points de contact (5), ainsi qu'une encapsulation élastique (11) et au moins un composant électronique (8), qui est relié électriquement avec les points de contact (5), la structure de contact étant conçue comme une structure de contact élastique qui se déploie, et les pistes conductrices (2) se terminant par des surfaces de contact (3) disposées au bord du support de circuit (30),
les pistes conductrices étant conçues de façon à ce que, à proximité des points de contact (5), une distance (4a) entre les pistes conductrices soit nettement inférieure à une distance (4b) à proximité des surfaces de contact (3).

8. Système électronique élastique selon la revendication 7, **caractérisé en ce que** l'au moins un composant électronique est un sous-système, une puce, un MEMS ou autre.

9. Système électronique élastique selon la revendication 7 ou 8, **caractérisé en ce qu'**au moins une surface de contact (3) est conçue comme un contact à bouton-poussoir ou un connecteur.

10. Système électronique élastique selon l'une des revendications 7 à 9, **caractérisé en ce que** les pistes conductrices (2) sont conçues comme des pistes conductrices (2) incurvées en alternance dans des directions opposées entre elles à partir d'une direction principale.

11. Système électronique élastique selon l'une des revendications 7 à 10, **caractérisé en ce que** le matériau élastique utilisé pour l'encapsulation (11) et/ou le matériau du substrat (1) présente un module d'élasticité inférieur à 0,2 GPa.

12. Système électronique élastique selon l'une des revendications 7 à 11, **caractérisé en ce qu'**un matériau élastique constituant l'encapsulation (11) ou un matériau constituant une grande partie du substrat (1) est un matériau thermoplastique comme le polyuréthane, le silicone, le caoutchouc ou le latex.

13. Surface à formes libres (13) avec au moins un système électronique élastique selon l'une des revendications 7 à 12, le système électronique étant appliqué fermement sur la surface à formes libres (13).

14. Surface à formes libres (13) avec au moins un système électronique élastique selon la revendication 13, **caractérisée en ce que** la surface à formes libres (13) est un support textile ou de type feutre, un film (24) ou une surface à formes libres rigide (13).

15. Surface à formes libres (13) avec au moins un système électronique élastique selon l'une des revendications 13 à 14, **caractérisée en ce que** les surfaces de contact (3) sont reliées avec des moyens pour la mise en contact.
